# EUROPÄISCHE PATENTSCHRIFT

(11) **EP 0 899 771 B1**
(45) Veröffentlichungstag und Bekanntmachung des Hinweises auf die Patenterteilung: **06.10.2004**
(21) Anmeldenummer: 98114706.9
(22) Anmeldetag: 05.08.1998
(51) Int. Cl.: H01J 37/05

(54) **Energiefilter, insbesondere für ein Elektronenmikroskop**
Energy filter, particularly for electron microscope
Filtre en énergie, en particulier pour microscope électronique

(30) Priorität: 01.09.1997 DE 19738070
(43) Veröffentlichungstag der Anmeldung: 03.03.1999
(73) Patentinhaber: LEO Elektronenmikroskopie GmbH, 73446 Oberkochen (DE)
(72) Erfinder: Benner, Gerd, Dr., 73434 Aalen (DE)
(74) Vertreter: Gnatzig, Klaus

(56) Entgegenhaltungen:
- EP-A- 0 352 552
- DE-A- 3 423 149
- US-A- 4 740 704

## Beschreibung

Abbildende Energiefilter für Elektronenmikroskope sind beispielsweise aus der US-A 4,812,652, US-A 4,740,704, US-A 4,760,261 und US-A 5,449,914 bekannt. Diese Energiefilter weisen an ihrem Ausgang stets zwei ausgezeichnete Ebenen, die achromatische Bildebene und die Spektrumsebene auf, deren Abstand die sogenannte Helmholtzlänge ist und ca. 50 mm -70 mm beträgt. In der achromatischen Bildebene werden alle Strahlen unabhängig von ihrer Energie fokusiert, die von einem gemeinsamen Punkt des Objektes oder des Beugungsbildes ausgehen. Man spricht deshalb auch von einer Ortsfokusierung in der achromatischen Bildebene. In der Spektrumsebene werden dagegen die Strahlen gleicher Energie in einem Punkt fokusiert, so daß in energiedispersiver Richtung ein Spektrum des Elektronenstrahles entsteht. Man spricht deshalb in der Spektrumsebene auch von einer Energiefokusierung. Mit Hilfe eines Projektivsystems, bestehend aus einer Transferlinse und mindestens einer Projektivlinse kann entweder die achromatische Ebene oder die Spektrumsebene auf die Registrierebene, in der ein Leuchtschirm oder ein Elektronendetektor angeordnet ist, abgebildet werden. Mit einer in der Spektrumsebene angeordneten Schlitzblende, die in energiedispersiver Richtung eine definierte Breite aufweist, läßt sich ein Energiefenster für die Abbildung auswählen. Die Breite des Energiefensters ist dabei von der Anwendung abhängig. Für eine elastische Hellfeldabbildung und für die Energieverlustabbildung sind Energiebandbreiten im Bereich von 4-25 eV sinnvoll. Für eine Paralleldetektion eines Spektrum sollte ein Energiebereich von 50 eV bis 500 eV auswählbar sein.

In der US-A 4,812,652 ist zur Einstellung unterschiedlicher Energiebandbreiten in der Spektrumsebene eine Anordnung mit zwei Spaltkanten, die mechanisch gegeneinander bewegbar sind, vorgesehen. Mit dieser Anordnung lassen sich im Prinzip beliebige Spaltbreiten einstellen. Allerdings erfordert die symmetrische und parallele Bewegung der Spaltbacken eine aufwendige Mechanik. Und aufgrund der mechanischen Hystereseeffekte ist eine automatische reproduzierbare Einstellung der Energiebandbreite nur mit Hilfe einer Messung der Spaltbreite möglich. Da außerdem konstruktionsbedingt die beiden Spaltkanten in unterschiedlichen Ebenen angeordnet sein müssen, treten bei kleinen Energiebandbreiten Abschattungseffekte auf.

Alternativ ist es denkbar, auf einem in der Spektrumsebene angeordneten Blendenwechsler mehrere Spaltblenden unterschiedlicher Breite vorzusehen. Die Herstellung entsprechender Spaltblenden mit festen Spaltabmessungen ist relativ einfach und entsprechend billig. Allerdings erfordert die Variation der Energiebandbreite ein mechanisches Wechseln der Spaltblende durch den Blendenwechsler. Dadurch ist die Anzahl der auswählbaren Energiebandbreiten stark eingeschränkt. Und aufgrund der erforderlichen Positioniergenauigkeit von einem µm ist hier eine Automatisierung der Energiebandbreiteneinstellung sehr aufwendig.

Aus der US 5,013,913 und US 5,483,073 des Erfinders sind bereits Transmissionselektronenmikroskope bzw. Rasterelektronenmikroskope bekannt, bei denen die Einstellung unterschiedlicher Aperturblenden oder Leuchtfeldblenden durch elektronenoptische Auswahl einer geeigneten Blendenöffnung erfolgt. Dazu ist im Elektronenmikroskop jeweils eine Blende mit einer Vielzahl runden Blendenöffnungen mit unterschiedlichen Öffnungsdurchmessern angeordnet. Die Auswahl bzw. Einstellung auf eine Blende mit einem definierten Blendendurchmesser erfolgt durch Auslenkung und anschließende Rücklenkung des Elektronenstrahls. Im Unterschied zu den Bedingungen am ausgangsseitigen Ende eines Energiefilters steht jedoch im beleuchtungsseitigen Strahlengang viel mehr Platz zur Anordnung der Ablenksysteme zur Verfügung.

Ziel der vorliegenden Erfindung ist ein abbildendes Elektronen-Energiefilter, bei dem eine Umschaltung auf unterschiedliche Energiebandbreiten ohne mechanischen Justieraufwand des Bedieners erfolgen kann. Dieses Ziel wird durch ein Energiefilter mit den Merkmalen der Ansprüche 1 oder 7 erreicht. Vorteilhafte Ausgestaltungen der Erfindung ergeben sich aus den Merkmalen der abhängigen Ansprüche.

Das erfindungsgemäße Energiefilter weist zur Energieselektion eine Blendenanordnung in der Dispersionsebene oder einer zur Dispersionsebene konjugierten Ebene und mindestens ein der Blendenanordnung vorgeschaltetes Ablenksystem, welches eine Ablenkung des Elektronenstrahls bewirkt, auf. Die Einstellung unterschiedlicher Energiebandbreiten erfolgt durch unterschiedliche Erregung des Ablenksystems und daraus resultierende unterschiedliche Auslenkung des Elektronenstrahls relativ zur Blendenanordnung.

Die Einstellung der Energiebandbreite erfolgt beim erfindungsgemäßen Filter elektronenoptisch, wodurch jeglicher mechanischer Justieraufwand beim Wechsel der Energiebandbreite entfällt. Es braucht lediglich die Erregung des Ablenksystems und ggf. weiterer Ablenksysteme zur Rücklenkung des Elektronenstrahls zur optischen Achse beim Wechsel der Energiebandbreite geändert zu werden. Die Blendenanordnung selbst bleibt dabei relativ zur optischen Achse und relativ zum mechanischen Aufbau des Elektronenmikroskops ortsfest. Die Werte der unterschiedlichen Erregungen des Ablenksystems bzw. der Ablenksysteme können bei der ersten Inbetriebnahme des Gerätes empirisch ermittelt und abgespeichert sein. Beim späteren Betrieb des Gerätes wird dann auf diese abgespeicherten Werte zurückgegriffen, indem die Erregung des Ablenksystems bzw. der Ablenksysteme je nach gewünschtem Energiebereich auf die zugehörigen abgespeicherten Werte eingestellt wird.

Die Einstellung auf unterschiedliche Energiebandbreiten erfolgt durch Auslenkung senkrecht zur energiedispersiven Richtung des Filters. Zu dieser Auslenkung reicht ein eindimensionales - eine Ablenkung in nur einer Richtung bewirkendes - Ablenksystem aus, wenn gleichzeitig bei einer Änderung der Auslenkung auch die Erregung der dispersiven Elemente des Energiefilters geringfügig geändert wird, da dadurch geringfügige Fehljustierungen zwischen der senkrechten zur energiedispersiven Richtung und der Ablenkrichtung des Ablenksystems kompensiert werden können. Die dazu erforderliche relative Änderung der Erregung der dispersiven Elemente kann dabei kleiner als 1% sein, so daß diese Erregungsänderung keinen spürbaren Einfluß auf die Dispersion hat.

Zur Energieselektion können auf einer Blendenscheibe mehrere spaltförmige Öffnungen mit unterschiedlichen Spaltlängen vorgesehen sein, die durch schmale Zwischenstege voneinander getrennt sind. Die Stegbreite sollte jedoch maximal 10 % der Spaltbreite betragen. Alternativ kann die Blendenanordnung nur eine einzige Öffnung mit abgestuftem Rand aufweisen, die in Abhängigkeit von der Position senkrecht zur energiedispersiven Richtung unterschiedliche Öffnungslängen in energiedispersiver Richtung aufweist. Mit einer solchen Blendenanordnung ergibt sich eine größere Anzahl an einstellbaren Energiebandbreiten, da die unterschiedlichen Spaltlängen durch Auswahl unterschiedlicher Bereiche ein und der selben Öffnung ausgewählt werden.

Bei einem einfachen Ausführungsbeispiel der Erfindung erfolgt die Auslenkung um einen realen oder virtuellen Kippunkt, der mit dem Schnittpunkt der optischen Achse mit der Ausgangsbildebene des Filters zusammenfällt. Mit Hilfe einer der Blendenanordnung nachgeschalteten Tranferlinse, die die Ausgangsbildebene des Filters in eine dazu konjugierte Ebene abbildet, wird erreicht, daß die zentrale Lage der achromatischen Ebene erhalten bleibt. Es findet demzufolge keine Bildauswanderung in Abhängigkeit von der gewählten Energiebandbreite statt. Für die Auslenkung reicht dann, wenn die achromatische Bildebene in Strahlrichtung gesehen weit genug hinter den dispersiven Komponenten des Filters liegt und demzufolge ein Ablenksystem in der achromatischen Bildebene angeordnet werden kann, ein einzelnes Ablenksystem in der achromatischen Bildebene aus. Liegt die achromatische Bildebene jedoch zu nahe an den dispersiven Elementen - oder sogar innerhalb der dispersiven Elemente - und ist deshalb für ein Ablenksystem nicht zugänglich, ist ein Doppelablenksystem erforderlich, dessen beiden Komponenten derart erregt werden, daß die Ablenkung um einen virtuellen Kippunkt in der achromatischen Bildebene erfolgt. Nachteilig ist an dieser Anordnung jedoch, daß sowohl die Transferlinse als auch die nachfolgenden Linsen für die weitere Abbildung je nach ausgewählter Energiebandbreite unterschiedlich stark außerachsial durchstrahlt werden, so daß unter Umständen von der ausgewählten Energiebandbreite abhängige Bildfehler auftreten können.

Das Problem der von der ausgewählten Energiebandbreite abhängigen Abbildungsfehler läßt sich gemäß eines weiterhin bevorzugten Ausführungsbeispiels dadurch umgehen, daß vor der Blendenanordnung ein Doppelablenksystem und der Transferlinse ein weiteres einfaches Ablenksystem nachgeschaltet ist. Die beiden Elemente des Doppelablenksystems werden dabei in Kombination stets so erregt, daß der Elektronenstrahl unabhängig von der ausgewählten Energiebandbreite und damit unabhängig von der Position auf der Blendenanordnung stets zentral durch die Transferlinse verläuft. Die hinter der Transferlinse verbleibende Bildauslenkung wird dann durch das einfache Ablenksystem so kompensiert, daß in der Bildebene der Transferlinse keine Bildverschiebung auftritt. Demzufolge tritt auch bei den nachfolgenden Abbildungsstufen keine von der ausgewählten Energiebandbreite abhängige außerachsiale Durchstrahlung auf.

Alternativ ist das Problem der von der ausgewählten Energiebandbreite abhängigen Bildfehler auch dadurch umgehbar, daß drei einfache Ablenksysteme vor der Transferlinse angeordnet sind, von denen eines eine Kippung in der Spektrumsebene bewirkt. Das der Spaltanordnung vorgeschaltete Ablenksystem bewirkt eine Auslenkung des Elektronenstrahls von der optischen Achse, das in der Spektrumsebene angeordnete Ablenksystem eine Rücklenkung zur optischen Achse und das nachfolgende Ablenksystem eine weitere Kippung derart, daß der Elektronenstrahl nachfolgend zentrisch zur optischen Achse verläuft.

Bei einem Ausführungsbeispiel, bei dem die Energiebandbreite kontinuierlich einstellbar ist, sind zwei Blendenanordnungen in zwei konjugierten Ebenen angeordnet. Beide Blendenanordnungen können dabei aus einfachen Spaltkanten bestehen. Zwischen beiden Blendenebenen ist in einer zur achromatischen Bildebene konjugierten Ebene ein Ablenksystem vorgesehen. Mit dem der ersten Blendenanordnung vorgeschalteten Ablenksystem wird der Elektronenstrahl so ausgelenkt, daß entweder der obere oder der untere Teil des Spektrums durch die Blendenanordnung abgeschnitten wird. Durch das zweite Ablenksystem wird dann der Elektronenstrahl wiederum so ausgelenkt, daß durch die zweite Blendenanordnung die Energiefilterung am entgegengesetzten Ende des Spektrums erfolgt. Das erfindungsgemäße Energiefilter wird vorzugsweise in einem Elektronenmikroskop eingesetzt, das eine Anordnung aus mehreren Abbildungsstufen zur Variation der Vergrößerung der elektronenoptischen Abbildung dem Energiefilter vorgeschaltet aufweist.

Nachfolgend werden Einzelheiten der Erfindung anhand der in den Figuren dargestellten Ausführungsbeispiele näher erläutert. Im einzelnen zeigen:
- Figur 1a: den Schnitt durch ein Transmissionselektronenmikroskop mit einem Energiefilter nach einem ersten Ausführungsbeispiel der vorliegenden Erfindung;
- Figur 1b: eine Detaildarstellung des Strahlenganges am Ausgang des Energiefilters beim Ausführungsbeispiel nach Figur 1a in einer zur Figur 1a senkrechten Ebene;
- Figur 1c: eine Dateidarstellung des Strahlenganges am Ende des Energiefilters für ein vereinfachtes Ausführungsbeispiel der Erfindung;
- Figur 2: eine Aufsicht auf eine Blendenanordnung bei den Energiefiltern nach den Figuren 1a - 1c;
- Figur 3: eine Dateidarstellung des Strahlenganges im hinteren Teil des Energiefilters für ein weiteres Ausführungsbeispiel der Erfindung;
- Figuren 4a und 4b: Prinzipskizzen des Strahlenganges im hinteren Teil des Energiefilters für ein erstes Ausführungsbeispiel mit kontinuierlich einstellbarer Energiebandbreite und
- Figuren 5a und 5b: die Prinzipskizze des Strahlenganges im hinteren Teil des Energiefilters für ein zweites Ausführungsbeispiel mit kontinuierlich einstellbarer Energiebandbreite.

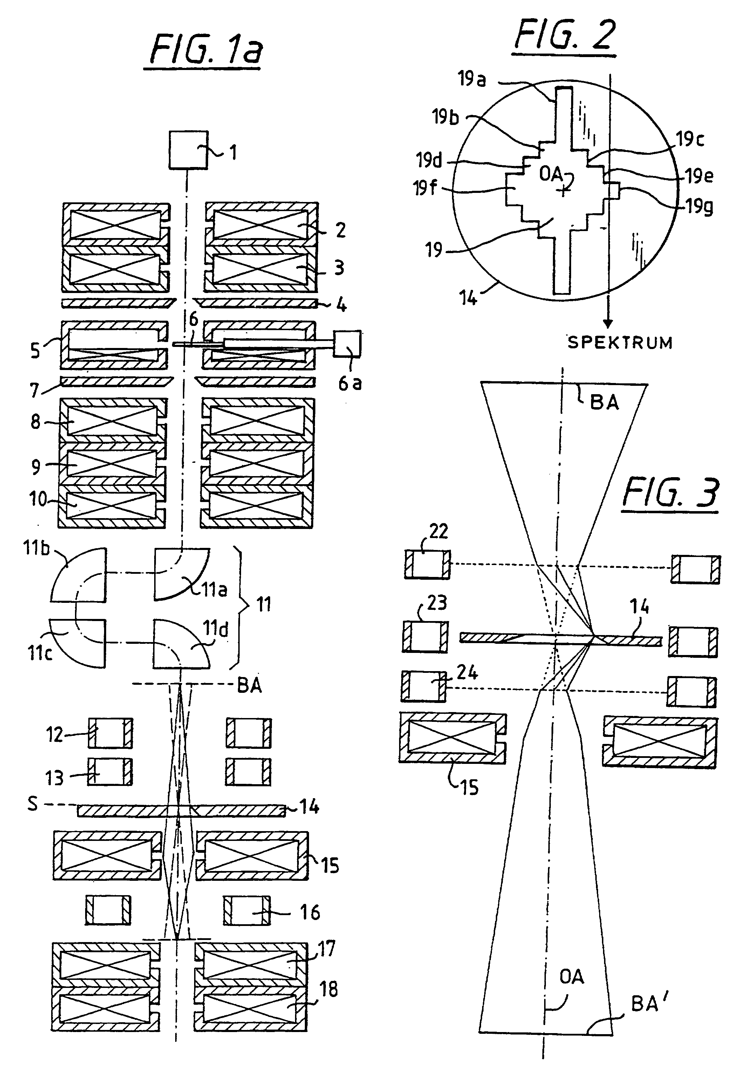

Der obere Teil des in der Figur 1a dargestellten Transmissionselektronenmikroskops weist einen konventionellen, aus der US 4 812 652 bekannten Aufbau auf. Die Elektronenquelle ist mit (1) bezeichnet. Mittels eines der Elektronenquelle (1) nachgeschalteten zweistufigen Kondensors (2, 3) wird aus den aus der Elektronenquelle (1) austretenden Elektronen ein kollimierter Elektronenstrahl erzeugt, dessen Appertur durch den Öffnungsdurchmesser der Apperturblende (4) bestimmt ist. Mit diesem kollimierten Elektronenstrahl wird das im Polschuhspalt des Objektivs (5) positionierte Objekt (6) beleuchtet. Für eine Manipulation des Objektes (6) ist dieses auf einem durch die Objektivlinse (5) hindurchgeführten Manipulator (6a) angeordnet.

Mittels drei der Objektivlinse (5) nachgeschalteten, ebenfalls als Magnetlinsen ausgebildeten Abbildungsstufen (8, 9, 10) wird ein vergrößertes Bild des Objektes (6) oder des Beugungsdiagrammes des Objektes (6) in der nicht dargestellten Eingangsbildebene des Energiefilters (11 - 16) erzeugt. Die Größe des übertragenen Bildfeldes wird dabei durch den Öffnungsdurchmesser der dem Objektiv (5) nachgeschalteten Feldblende (7) bestimmt.

Die Abbildungsbedingungen vor dem Eintritt in das Energiefilter (11 - 16) entsprechen dabei den in der US-A 4 812 652 beschriebenen Abbildungsbedingungen, so daß unabhängig von der eingestellten Vergrößerung bei der Objektabbildung ein Bild des Objektes in der Eingangsbildebene des Filters (11 - 16) und ein Bild der Eleketronenquelle (1) in der Eingangs-Crossover-Ebene des Filters (11 - 16) liegt. Bei der Aufnahme von Objektbeugungsdiagrammen liegt ein Bild der Elektronenquelle (1) in der Eingangsbildebene des Energiefilters (11 - 16) und ein Bild des Objektes (6) in der Eingangs-Crossover-Ebene des Energiefilters (11 - 16). In der Eingangsbildebene oder nahe der Eingangsbildebene ist eine die Ausdehnung der Kaustik begrenzende, nicht dargestellt Feldblende angeordnet, deren Öffnungsdurchmesser so gewählt ist, daß die Registrierfläche des Detektors voll ausgeleuchtet wird.

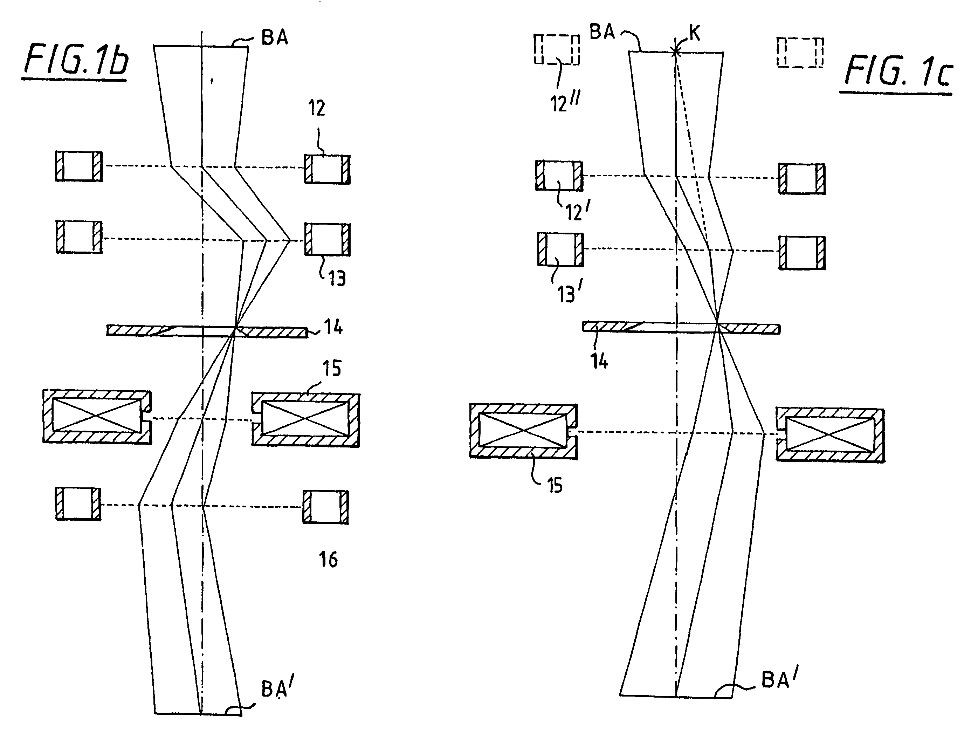

Die dispersiven Komponenten (11, 11a - 11d) des Energiefilters sind als sogenanntes Omegafilter entsprechend der US 4 740 704 oder entsprechend der US 5 449 914 aufgebaut. Die dispersiven Komponenten des Filters bilden die Eingangsbildebene achromatisch in die Ausgangsbildebene (BA) und die Eingangs-Crossover-Ebene dispersiv in die Spektrumsebene (S) ab. Der hintere Teil des Energiefilters ist dabei in der Figur 1 aus Übersichtlichkeitsgründen entlang der optischen Achse stark verlängert dargestell; in der Realität liegt die Ausgangsbildebene (achromatische Bildebene) (BA) etwa in der Mitte des letzten Sektormagneten (11d) des Filters und die Spektrumsebene (S) in einem Abstand hinter dem letzten Sektormagneten (11d), welcher der Größenordnung des Umlenkradius in den Sektormagneten (11a - 11d) entspricht.

Der ausgangsseitige Teil des Energiefilters enthält zwischen der achromatischen Bildebene (BA) und der Spektrumsebene (S) ein Doppelablenksystem (12, 13), dessen Komponeneten jeweils als eindimensionale - eine Ablenkung in nur einer Richtung bewirkende - Ablenksysteme ausgebildet sind, und in der Spektrumsebene eine Blendenanordnung (14). Hinter der Spektrumsebene (S) folgt in Strahlrichtung gesehen eine Transferlinse (15) und ein weiteres einfaches Ablenksystem (16). Das Doppelablenksystems (12, 13) bewirkt in Abhängigkeit von der einzustellenden Energiebandbreite senkrecht zur dispersiven Richtung des Filters, d.h. senkrecht zur Zeichenebene in Figur 1a eine Auslenkung des Elektronenstrahls derart, daß der Elektronenstrahl in der Spektrumsebene auf den die gewünschte Energiefilterung bewirkenden Bereiche der Blendenanordnung fällt, und gleichzeitig, unabhängig von der gewählten Energiebandbreite stets zentral durch die Transferlinse (15) verläuft. Durch diese Wahl der Ablenkung durch das Doppelablenksystem (12, 13) wird erreicht, daß die Transferlinse (15) keine von der eingestellten Energiebandbreite abhängigen Fehler erzeugt. Die Transferlinse (15) ist so erregt, daß die achromatische Bildebene (BA) in eine dazu konjugierte achromatische Bildebene (BA') hinter dem weiteren einzelnen Ablenksystem (16) abgebildet wird. Das weitere einfache Ablenksystem (16) ist so erregt, daß das in der zur achromatischen Bildebene (BA) konjugierten Bildebene (BA') entstehende Bild wieder symetrisch zur optischen Achse liegt. Durch das nachfolgende Projektivsystem (17, 18) wird dann das in der konjugierten Bildebene BA' entstehende Bild vergrößert in die hier nicht mehr dargestellte Registrierebene auf einen Leuchtschirm oder Bilddetektor abgebildet. Die Einstellung des Projektivsystems (17, 18) ist hier wiederum analog zu dem aus der US 4 812 652 bekannten Elektronenmikroskop.

Die durch das Doppelablenksystem (12, 13) bewirkte Auslenkung des Elektronenstrahls und die durch das einfache Ablenksystem (16) bewirkte Zurückkippung des Elektronenstrahls erfolgt dabei senkrecht zur Spektrumsrichtung und damit senkrecht zur Zeichenebene in Figur 1a. Dieser Sachverhalt ist in der Figur 1b vergrößert dargestellt. Bei einer Änderung der durch das Doppelablenksystem (12, 13) bewirkten Ablenkung des Elektronenstrahls wird gleichzeitig die Erregung der dispersiven Elemente (11a - 11d) des Filters (11) geringfügig geändert. Dadurch wird ohne kostruktiven Zusatzaufwand erreicht, daß auch bei geringfügigen Fehljustierungen zwischen der senkrechten zur dispersiven Richtung des Filters (11) und der Ablenkrichtung des Doppelablenksystems (12, 13) die bewirkte Auslenkung senkrecht zur energiedispersiven Richtung erfolgt.

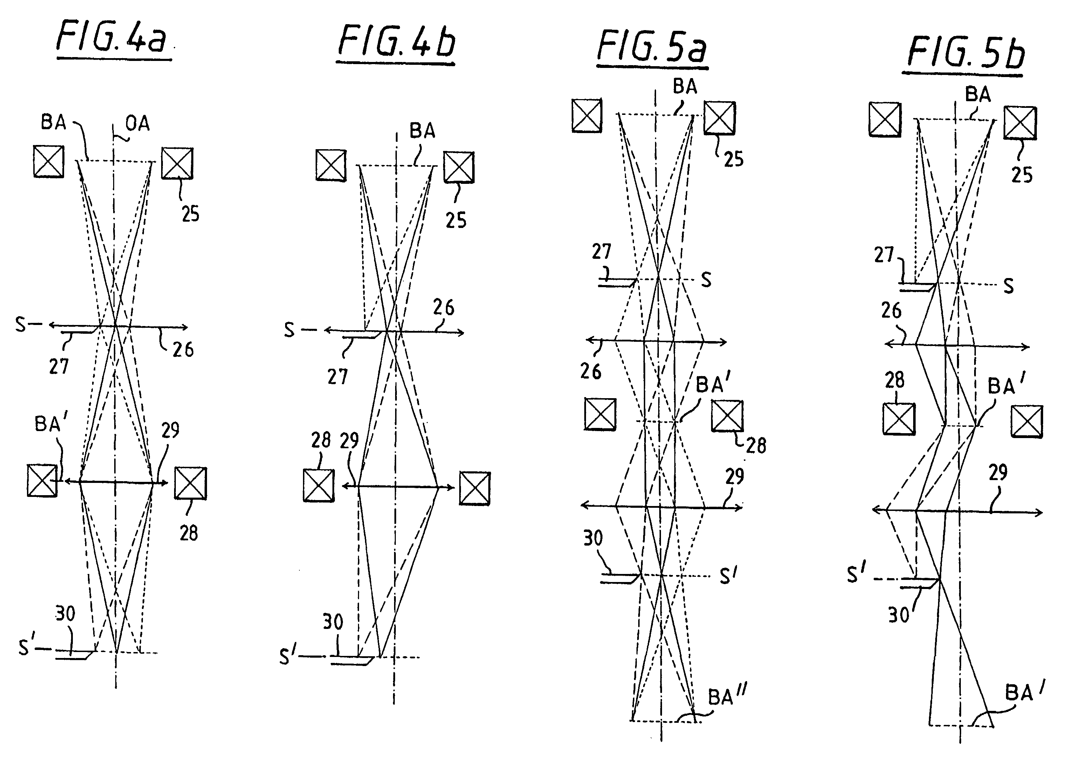

Die Blendenanordnung (14) ist in der Figur 2 in Aufsicht dargestellt. Diese Blendenanordnung (14) ist im Elektronenmikroskop der Figur 1a senkrecht zur Zeichenebene in Figur 1a derart angeordnet, daß der die Richtung des Spektrums andeutende Pfeil in Figur 2 in Dispersionsrichtung und damit parallel zur Zeichenebene in Figur 1a ausgerichtet ist. Die Blendenanordnung weist eine einzige Öffnung (19) mit einer abgestuften Umrandung auf. Durch die abgestufte Umrandung entstehen Bereiche (19a - 19g), die für unterschiedliche Energiebandbreiten auswählbar sind. Die Abstufung ist dabei in Spektrumsrichtung jeweils symetrisch zu der Ebene, in der die optische Achse (OA) die Blendenanordnung (14) schneidet. Die Blendenanordnung selbst hat senkrecht zur Zeichenebene in Figur 2 am Rand der Öffnung (19) eine Dicke von 5µm, die mit dem Abstand von der Öffnung (19) auf 100µm zunimmt. Durch die relativ dicke Ausbildung in Entfernung von der Blendenöffnung (19) wird sichergestellt, daß Elektronen, die im Objekt (6) keinen Energieverlust erfahren haben, nicht durch die Blende transmittieren können. Gleichzeitig wird durch die relativ dünne Ausbildung im Bereich der Blendenöffnung (19) erreicht, daß sich die Blendenkanten genügend aufheizen, damit eine sich auf der Blendenanordnung ablagernde Verschmutzung abgebrannt wird. Die sinnvolle Abmessung der Bereiche (19a - 19g) senkrecht zur energiedispersiven Richtung hängt von der Ausdehnung der Kaustik ab und beträgt zwischen 0,1 und 0,15 mm.

Die Abstufungen der Blendenöffnung (19) sind bezüglich ihrer Länge in Abhängigkeit von der Dispersion des Filters so ausgewählt, daß bei Einstellung des Elektronenstrahls auf die längste Blendenöffnung (19a) eine Energiebandbreite von 500 eV und bei Einstellung auf den kürzesten Blendenbereich (19g) eine Energiebandbreite von 4 eV realisiert wird.

In der Figur 1c ist der Strahlengang eines vereinfachten Ausführungsbeispiels in einer zur Zeichenebene der Figur 1a senkrechten Ebene dargestellt. Bei diesem Ausführungsbeispiel ist auf das einfache Ablenksystem (16) hinter der Transferlinse (15) verzichtet. Damit dennoch keine Bildverschiebung in der zur achromatischen Bildebene (BA) konjugierten achromatischen Bildebene (BA') auftritt, ist das Doppelablenksystem (12', 13') derart erregt, daß eine Auslenkung des Elektronenstrahls um einen virtuellen Kippunkt (K) erfolgt, der in der achromatischen Bildebene (BA) auf der optischen Achse liegt. Die Rücklenkung des Elektronenstrahls erfolgt dann ausschließlich durch die Transferlinse (15). Allerdings verläuft der Strahlengang bei dieser Anordnung in der Transferlinse (15) und auch im nachfolgenden Projektivsystem (17, 18) (siehe Figur 1a) außerachsial, so daß hier von der eingestellten Energiebandbreite abhängige Abbildungsfehler auftreten können.

Das in der Figur 1c dargestellte vereinfachte Ausführungsbeispiel läßt sich noch weiter vereinfachen, wenn die achromatische Bildebene (BA) hinter den dispersiven Elementen des Filters liegt und demzufolge zugänglich ist. In diesem Fall kann, wie in der Figur 1c gestrichelt angedeutet ist, anstelle des Doppelablenksystems (12', 13') auch ein einfaches Ablenksystem (12'') in der achromatischen Bildebene (BA) angeordnet sein.

Bei beiden Ausführungsformen nach der Figur 1c ist die Blendenanordnung (14) entsprechend der Figur 2 ausgebildet.

Das in der Figur 3 dargestellte Ausführungsbeispiel ist bezüglich der Abbildungseigenschaften mit dem Ausführungsbeispiel nach den Figuren 1a und 1b vergleichbar. Dieses Ausführungsbeispiel enthält zusätzlich zur Transferlinse (15), die wiederum die Abbildung der achromatischen Bildebene (BA) in die dazu konjugierte achromatische Bildebene (BA') bewirkt, drei einzelne Ablenksysteme (22, 23, 24), die alle in Strahlrichtung gesehen vor der Transferlinse (15) angeordnet sind. Das mittlere Ablenksystem (23) ist dabei in der Spektrumsebene angeordnet. Das erste Ablenksystem bewirkt eine Auslenkung des Elektronenstrahls entsprechend der ausgewählten Energiebandbreite, das mittlere Ablenksystem (23) eine Rücklenkung des Elektronenstrahls auf die optische Achse und das dritte Ablenksystem eine Kippung derart, daß der Elektronenstrahl hinter dem dritten Ablenksystem (24) symetrisch zur optischen Achse OA verläuft. Auch bei diesem Ausführungsbeispiel ist die Blendenanordnung (14) in der Spektrumsebene entsprechend der Figur 2 ausgebildet.

In den Abbildungen 4a und 4b ist der Strahlengang eines Systems zur variablen Spaltbreitenwahl dargestellt, das die achromatische Bildebene (BA) und das Spektrum im Abbildungsmaßstab 1:1 überträgt, wobei auch noch der Abstand (Helmholzlänge) zwischen der achromatischen Bildebene und der Spektrumsebene erhalten bleibt. Dieses Ausführungsbeispiel weist in Strahlrichtung gesehen zunächst wieder ein Ablenksystem (25) auf, das eine Kippung um die optische Achse (OA) in der achromatischen Bildebene (BA) bewirkt. Bei zugänglicher achromatischer Bildebene reicht dafür wieder ein einfaches Ablenksystem aus. Sollte die achromatische Bildebene nicht zugänglich sein, ist das Ablenksystem (25) als Doppelablenksystem ausgebildet, das hinter der achromatischen Bildebene (BA) angeordnet ist und so erregt ist, daß ein virtueller Kippunkt um den Schnittpunkt der optischen Achse mit der achromatischen Bildebene resultiert. In der Spektrumsebene ist im Polschuhspalt einer ersten Transferlinse (26) die aus einer Spaltkante bestehende erste Blendenanordnung (27) angeordnet. Die Transferlinse (26) bildet die achromatische Bildebene (BA) in eine dazu konjugierte Ebene (BA') ab. In dieser konjugierten Ebene (BA') ist eine zweite Linse (29) und ein zweites Ablenksystem (28) angeordnet. Die zweite Linse (29) wirkt dadurch gewissermaßen als Feldlinse und bildet die Spektrumsebene (S) in eine dazu konjugierte Spektrumsebene (S') ab. Die erste Spaltkante (27) dient zur Filterung entweder des oberen oder des unteren Ende des Spektrums während die zweite Spaltkante (30) zur Filterung am anderen Ende des Spektrums dient. In der Figur 4a ist der Strahlengang dargestellt für den Fall, daß die Ablenksysteme (25, 28) beide nicht erregt sind. Die erste Transferlinse (26) bewirkt aufgrund ihrer Anordnung in der Spektrumsebene lediglich eine Bilddrehung des Spektrums. Diese Linse überträgt die achromatische Bildebene (BA) im Abbildungsmaßstab 1:1 in die dazu konjugierte Ebene (BA') die zugleich mit der Hauptebene der zweiten Transferlinse (29) zusammenfällt. Bei nicht erregten Ablenksystemen (25, 28) wird neben der Sollenergie E₀ (durchgezogene Linie) der gesamte Energiebereich bis E₀ - Δ E (gepunktete Linie) und E₀ + Δ E (gestrichelte Linie) selektiert. Durch eine geeignete Erregung der Ablenksysteme (25, 28) läßt sich eine beliebig kleinere Energiebandbreiten einstellen. Dieser Sachverhalt ist in der Figur 4b veranschaulicht, in der der niederenergetische Bereich (gestrichelte Linie) teilweise durch die erste Spaltkante (27) und der höherenergetische Energiebereich (gestrichelte Linie) durch die zweite Spaltkante ausgefiltert wird.

Der in den Figuren 4a und 4b dargestellten Anordnung folgt wiederum ein Projektivsystem entsprechend der Figur 1a nach, durch das entweder das Spektrum oder die achromatische Ebene in die Registrierebene abgebildet wird.

Bei dem in den Figuren 5a und 5b dargestellten alternativen Ausführungsbeispiel ist die erste Transferlinse (26) hinter der Spektrumsebene (S) so angeordnet, daß sich die Spektrumsebene (S) im vorderen Brennpunkt der Transferlinse (26) befindet. Gleichzeitig bildet die erste Transferlinse (26) wiederum die achromatische Bildebene (BA) in eine dazu konjugierte Ebene (BA') ab. Dieser konjugierten Ebene folgt eine zweite Transferlinse (29), die identisch zur ersten Transferlinse (26) erregt ist. In der Brennebene der zweiten Transferlinse (29) entsteht ein Bild (S') der Spektrumsebene. Gleichzeitig bildet die zweite Transferlinse (29) die zur achromatischen Bildebene (BA) konjugierte Ebene (BA') in die Ausgangsbildebene (BA'') ab. Durch die teleskopische Anordnung der beiden Linsen (26, 29) werden sowohl die Spektrumsebenen (S, S') mit dem Abbildungsmaßstab 1:1 als auch die achromatische Bildebene (BA) in die Ausgangsebene (BA'') im Abbildungsmaßstab 1:1 abgebildet.

Die Energiebreiteneinstellung erfolgt analog zum Ausführungsbeispiels nach den Figuren 4a und 4b durch entsprechende Erregung der beiden Ablenksysteme (25 und 28) in der achromatischen Bildebene und in der dazu konjugierten Ebene (BA'). Durch eine Spaltkante (27) in der Spektrumsebene (S) wird wiederum der niederenergetische und durch eine zweite Spaltkante (30) in der zur Spektrumsebene (S) konjugierten Ebene (S') der höherenergetische Anteil des Spektrums herausgefiltert. Welche der beiden Spaltblenden (27, 30) dabei auf den niederenergetischen bzw. hochenergetischen Teil des Spektrums wirkt, ist dabei unwesentlich, da dieses nur davon abhängt, auf welcher Seite der optischen Achse die Spaltkanten (27, 30) angeordnet sind. Zu bemerken ist, daß bei der Anordnung nach den Figuren 5a und 5b die zur Spektrumsebene (S) konjugierte Ebene (S') und die achromatische Ausgangsebene (BA'') in der Reihenfolge gegenüber der achromatischen Bildebene (BA) und der Spektrumsebene (S) vertauscht sind. Durch diese Vertauschung von achromatischer Bildebene und Spektrumsebene ist dieses Ausführungsbeispiel insbesondere bei Energiefiltern mit hoher Dispersion vorteilhaft, da mit dem nachfolgenden Projektivsystem kleinere Vergrößerungen bei der Spektrumsabbildung ermöglicht werden.

Es ist offensichtlich, daß bei den Ausführungsbeispielen in den Figuren 4a, 4b und 5a, 5b die durch die Ablenksysteme (25, 28) bewirkte Auslenkung des Elektronenstrahls in energiedispersiver Richtung des Filters erfolgt.

## Patentansprüche

1. Elektronenenergiefilter, insbesondere für ein Elektronenmikroskop, das eine Ausgangsbildebene (BA) und eine Dispersionsebene (S) aufweist, mit einer Blendenanordnung (14, 27, 30) zur Energieselektion in der Dispersionsebene (S) oder einer zur Dispersionsebene (S) konjugierten Ebene (S'), **dadurch gekennzeichnet, dass** ein der Blendenanordnung (14, 27, 30) vorgeschaltetes Ablenksystem (12, 13; 12', 13'; 12', 25) vorgesehen ist, welches eine Ablenkung des Elektronenstrahls bewirkt und dass die Einstellung unterschiedlicher Energiebandbreiten durch unterschiedliche Erregungen des Ablenksystems (12, 13; 12', 13'; 12'', 25, 28) und daraus resultierende unterschiedliche Auslenkungen des Elektronenstrahls relativ zur Blendenanordnung (14, 27, 30) senkrecht zur energiedispersiven Richtung des Elektronenenergiefilters (11, 12, 13, 14) erfolgt.

2. Elektronenenergiefilter nach Anspruch 1, wobei bei einer Änderung der Erregung des Ablenksystems (12, 13; 12', 13';12', 25, 2B) eine Änderung der Erregung dispersiver Elemente (11a - 11d) des Elektronenenergiefilters erfolgt.

3. Elektronenenergiefilter nach einem der Ansprüche 1 - 2, wobei die Auslenkung um einen realen oder virtuellen Kippunkt (K) erfolgt, der mit dem Schnittpunkt der optischen Achse (OA) mit der Ausgangebildebene (BA) zusammenfällt

4. Elektronenenergiefilter nach einem der Ansprüche 1 - 3, wobei der Blendenanordnung (14) eine Transferlinse (15; 26) zur Abbildung der Ausgangebildebene (BA) nachgeordnet ist.

5. Elektronenenergiefilter nach einem der Ansprüche 1 - 4, wobei der Blendenanordnung (14) ein weiteres Ablenksystem (16; 24; 28) nachgeordnet ist.

6. Elektronenenergiefilter nach einem der Ansprüche 1 - 5, wobei die Blendenanordnung (14) eine oder mehrere Öffnungen (19) aufweist, die in Abhängigkeit von der Position senkrecht zur energiedispersiven Richtung unterschiedliche Öffnungslängen (19a - 19g) aufweisen.

7. Elektronenenergiefilter, insbesondere für ein Elektronenmikroskop, das eine Ausgangsbildebene (BA) und eine Dispersionsebene (S) aufweist, mit einer Blendenanordnung (14, 27, 30) zur Energieselektion in der Dispersionsebene (S) oder einer zur Diapersionsebene (S) konjugierten Ebene (S'), **dadurch gekennzeichnet, dass** eine erste Blendenanordnung (27) und eine zweite Blendenanordnung (30) vorgesehen ist, dass zwischen der ersten und zweiten Blendenanordnung mindestens eine Transferlinse(26, 29) angeordnet ist, die die erste Blendenanordnung (27) auf die zweite Blendenanordnung (30) abbildet, dass weiterhin zwischen der ersten und zweiten Blendenanordnung ein Ablenksystem (28) vorgesehen ist, welches eine Ablenkung des Elektronenstrahls bewirkt, so dass die Einstellung unterschiedlicher Energiebandbreiten durch unterschiedliche Erregungen des Ablenksystems (28) und daraus resultierende unterschiedliche Auslenkungen des Elektronenstrahls relativ zur zweiten Blendenanordnung (30) erfolgt.

8. Elektronenenergiefilter nach Anspruch 7, wobei die erste und zweite Blendenanordnung (27, 30) als Spaltkanten ausgebildet sind.

9. Elektronenenergiefilter nach Anspruch 7 oder 8, wobei das Ablenksystem (28) in einer zur Ausgangsbildebene (BA)des Elektronenenergiefilters konjugierten Ebene (BA') angeordnet ist.

10. Elektronenenergiefilter nach einem der Ansprüche 7 - 9, wobei der zweiten Blendenanordnung (30) eine zweite Transferlinse (29) vorgeschaltet ist.

11. Elektronenenergiefilter nach einem der Ansprüche 7 bis 10, wobei weiteres Ablenksystem (25) - in Strahlrichtung gesehen - vor der ersten Blendenanordnung (27) angeordnet ist.

12. Elektronenenergiefilter nach Anspruch 11, wobei das weitere Ablenksystem (25) eine Auslenkung um einen realen oder virtuellen Kippunkt (K) bewirkt, der mit dem Schnittpunkt der optischen Achse (OA) mit der Ausgangsbildebene (BA) zusammenfällt.

13. Elektronenenergiefilter nach einem der Ansprüche 7 bis 12, wobei bei einer Änderung der Erregung des Ablenksystems/der Ablenksysteme (25, 28) eine Änderung der Erregung dispersiver Elemente (11a - 11d) des Elektronenenergiefilters erfolgt.

14. Elektronenmikroskop mit einem Elektronenenergiefilter nach einem der Ansprüche 1 - 13, wobei dem Elektronenenergiefilter (11 - 16) eine Anordnung aus mehreren Abbildungsstufen (5, 8, 9, 10) zur Variation der Vergrößerung der elektronenoptischen Abbildung vorgeschaltet ist.

15. Elektronenmikroskop nach Anspruch 14, wobei die Lagen der Eingangsbildebene und der Eingangs-Crossover-Ebene des Filters (11 - 16) unabhängig von der eingestellten Vergrößerung ortsfest sind.

## Claims

1. Electron energy filter, particularly for an electron microscope, which has an output image plane (BA) and a dispersion plane (S) with a diaphragm arrangement (14, 27, 30) for energy selection in the dispersion plane (S) or a plane (S') conjugate with the dispersion plane (S), **characterized in that** a deflecting system (12, 13; 12', 13'; 12', 25) is provided which is upstream of the diaphragm arrangement (14, 27, 30), and which effects a deflection of the electron beam, and **in that** different energy bandwidths are set by different excitations of the deflecting system (12, 13; 12', 13'; 12'', 25, 28) and different deflections, resulting therefrom, of the electron beam relative to the diaphragm arrangement (14, 27, 30) perpendicular to the energy-dispersive direction of the electron energy filter (11, 12, 13, 14).

2. Electron energy filter according to Claim 1, in which in the event of a change in the excitation of the deflecting system (12, 13; 12', 13'; 12', 25, 28) there is a change in the excitation of dispersive elements (11a - 11d) of the electron energy filter.

3. Electron energy filter according to one of Claims 1 - 2, in which the deflection takes place about a real or virtual tilting point (K) which coincides with the point of intersection of the optical axis (OA) with the output image plane (BA).

4. Electron energy filter according to one of Claims 1 - 3, in which for the purpose of imaging the output image plane (BA) a transfer lens (15; 26) is arranged downstream of the diaphragm arrangement (14).

5. Electron energy filter according to one of Claims 1 - 4, in which a further deflecting system (16; 24; 28) is arranged downstream of the diaphragm arrangement (14).

6. Electron energy filter according to one of Claims 1 - 5, in which the diaphragm arrangement (14) has one or more openings (19) which have different opening lengths (19a - 19g) as a function of the position perpendicular to the energy-dispersive direction.

7. Electron energy filter, in particular for an electron microscope, which has an output image plane (BA) and a dispersion plane (S) with a diaphragm arrangement (14, 27, 30) for energy selection in the dispersion plane (S) or a plane (S') conjugate with the dispersion plane (S), **characterized in that** a first diaphragm arrangement (27) and a second diaphragm arrangement (30) are provided, **in that** there is arranged between the first and second diaphragm arrangement at least one transfer lens (26, 29) which images the first diaphragm arrangement (27) onto the second diaphragm arrangement (30), and **in that**, furthermore, there is provided between the first and second diaphragm arrangement a deflecting system (28) which effects a deflection of the electron beam such that different energy bandwidths are set by different excitations of the deflecting systems (28) and different deflections, resulting therefrom, of the electron beam relative to the second diaphragm arrangement (30).

8. Electron energy filter according to Claim 7, in which the first and second diaphragm arrangements (27, 30) are designed as slit edges.

9. Electron energy filter according to Claim 7 or 8, in which the deflecting system (28) is arranged in a plane (BA') conjugate to the output image plane (BA) of the electron energy filter.

10. Electron energy filter according to one of Claims 7 - 9, in which a second transfer lens (29) is positioned upstream of the second diaphragm arrangement (30).

11. Electron energy filter according to one of Claims 7 to 10, in which a further deflecting system (25) is arranged upstream of the first diaphragm arrangement (27) when seen in the beam direction.

12. Electron energy filter according to Claim 11, in which the further deflecting system (25) effects a deflection about a real or virtual tilting point (K) which coincides with the point of intersection of the optical axis (OA) with the output image plane (BA).

13. Electron energy filter according to one of Claims 7 to 12, in which in the event of a change in the excitation of the deflecting system/the deflecting systems (25, 28) there is a change in the excitation of dispersive elements (11a - 11d) of the electron energy filter.

14. Electron microscope having an electron energy filter according to one of Claims 1 - 13, in which positioned upstream of the electron energy filter (11 - 16) is an arrangement composed of a number of imaging stages (5, 8, 9, 10) for varying the magnification of the electron-optical image.

15. Electron microscope according to Claim 14, in which the positions of the input image plane and the input crossover plane of the filter (11 - 16) are fixed independently of the magnification set.

## Revendications

1. Filtre à énergie électronique, notamment pour un microscope électronique, qui présente un plan d'image de sortie (BA) et un plan de dispersion (S), avec un arrangement obturateur (14, 27, 30) pour sélectionner l'énergie dans le plan de dispersion (S) ou un plan (S') conjugué par rapport au plan de dispersion (S), **caractérisé en ce qu'**il est prévu un système de déviation (12, 13 ; 12'', 13' ; 12', 25) monté en amont de l'arrangement obturateur (14, 27, 30), lequel effectue une déviation du faisceau d'électrons, et que le réglage des différentes largeurs de bande d'énergie s'effectue par des excitations différentes du système de déviation (12, 13 ; 12', 13' ; 12", 25, 28) et les différentes déviations qui en résultent du faisceau d'électrons par rapport à l'arrangement obturateur (14, 27, 30) perpendiculairement au sens de dispersion d'énergie du filtre à énergie électronique (11, 12, 13, 14).

2. Filtre à énergie électronique selon la revendication 1, avec lequel une modification de l'excitation du système de déviation (12, 13 ; 12', 13' ; 12'', 25, 28) entraîne une modification de l'excitation des éléments de dispersion (11a - 11d) du filtre à énergie électronique.

3. Filtre à énergie électronique selon l'une des revendications 1 à 2, avec lequel la déviation est effectuée autour d'un point de basculement (K) réel ou virtuel qui coïncide avec le point d'intersection de l'axe optique (OA) avec le plan d'image de sortie (BA).

4. Filtre à énergie électronique selon l'une des revendications 1 à 3, avec lequel une lentille de transfert (15 ; 26) est montée à la suite de l'arrangement obturateur (14) pour former le plan d'image de sortie (BA).

5. Filtre à énergie électronique selon l'une des revendications 1 à 4, avec lequel un système de déviation supplémentaire (16 ; 24 ; 28) est monté à la suite de l'arrangement obturateur (14).

6. Filtre à énergie électronique selon l'une des revendications 1 à 5, avec lequel l'arrangement obturateur (14) présente une ou plusieurs ouvertures (19) qui présentent des longueurs d'ouverture (19a - 19g) différentes en fonction de la position perpendiculaire au sens de dispersion de l'énergie.

7. Filtre à énergie électronique, notamment pour un microscope électronique, qui présente un plan d'image de sortie (BA) et un plan de dispersion (S), avec un arrangement obturateur (14, 27, 30) pour sélectionner l'énergie dans le plan de dispersion (S) ou un plan (S') conjugué par rapport au plan de dispersion (S), **caractérisé en ce qu'**il est prévu un premier arrangement obturateur (27) et un deuxième arrangement obturateur (30), qu'au moins une lentille de transfert (26, 29) est disposée entre le premier et le deuxième arrangement obturateur, laquelle représente le premier arrangement obturateur (27) sur le deuxième arrangement obturateur (30), qu'un système de déviation (28) est en plus prévu entre le premier et le deuxième arrangement obturateur, lequel effectue une déviation du faisceau d'électrons, de sorte que le réglage des différentes largeurs de bande d'énergie s'effectue par des excitations différentes du système de déviation (28) et les différentes déviations qui en résultent du faisceau d'électrons par rapport au deuxième arrangement obturateur (30).

8. Filtre à énergie électronique selon la revendication 7, avec lequel le premier et le deuxième arrangement obturateur (27, 30) sont réalisés sous la forme d'arêtes fendues.

9. Filtre à énergie électronique selon la revendication 7 ou 8, avec lequel le système de déviation (28) est disposé dans un plan (BA') conjugué par rapport au plan d'image de sortie (BA) du filtre à énergie électronique.

10. Filtre à énergie électronique selon l'une des revendications 7 à 9, avec lequel une deuxième lentille de transfert (29) est montée en amont du deuxième arrangement d'obturateur (30).

11. Filtre à énergie électronique selon l'une des revendications 7 à 10, avec lequel un système de déviation supplémentaire (25) est disposé avant le premier arrangement obturateur (27), vu dans le sens du faisceau.

12. Filtre à énergie électronique selon 1a revendication 11, avec lequel le système de déviation supplémentaire (25) réalise une déviation autour d'un point de basculement (K) réel ou virtuel qui coïncide avec le point d'intersection de l'axe optique (OA) avec le plan d'image de sortie (BA).

13. Filtre à énergie électronique selon l'une des revendications 7 à 12, avec lequel une modification de l'excitation du système de déviation / des systèmes de déviation (25, 28) entraîne une modification de l'excitation des éléments de dispersion (11a - 11d) du filtre à énergie électronique.

14. Microscope électronique équipé d'un filtre à énergie électronique selon l'une des revendications 1 à 13, avec lequel un arrangement composé de plusieurs étages de représentation (5, 8, 9, 10) destinés à faire varier le grossissement de la représentation électro-optique est monté avant le filtre à énergie électronique (11 - 16).

15. Microscope électronique selon la revendication 14, avec lequel les positions du plan d'image en entrée et du plan de crossover en entrée du filtre (11 - 16) sont fixes indépendamment du grossissement réglé.
